# DEMANDE DE BREVET EUROPEEN

(11) **EP 0 676 716 A1**
(43) Date de publication de la demande: **11.10.1995**
(21) Numéro de dépôt: 95103131.9
(22) Date de dépôt: 04.03.1995
(51) Int. Cl.: G06K 19/077

(54) **Support portable d'informations numériques**

(30) Priorité: 07.03.1994 CH 661/94
(71) Demandeur: Bauer, Eric, CH-2006 Neuchatel (CH)
(72) Inventeur: Bauer, Eric, CH-2006 Neuchatel (CH)
(74) Mandataire: Robert, Jean S.

(57) **Abrégé**

La carte informatique (1) comprend une antenne (4) de commande à distance, reliée à un micro-circuit intégré (puce) (5). La carte (1) est munie d'un second micro-circuit intégré (6) dont les mémoires sont programmables. Ces deux micro-circuits intégrés (5 et 6) sont juxtaposés sur un circuit imprimé commun (print) (7) sur les plages conductrices (8) duquel ils sont branchés.

## Description

La présente invention a pour objet un support portable d'informations numériques.

Deux types de supports portables d'informations numériques existent actuellement, comprenant l'un et l'autre un micro-circuit intégré du type dit "puce".

Dans un cas ce circuit intégré est relié à une antenne incorporée au support, de manière que ledit circuit puisse être interrogé à distance.

Dans le second cas le circuit intégré est relié à un circuit imprimé (print), de manière que ledit circuit puisse être interrogé, chargé ou modifié à l'aide des contacts physiques du circuit imprimé.

Le but de la présente invention est d'étendre le champ d'application des supports portables d'informations numériques.

Ce but est atteint grâce aux moyens définis dans la revendication 1.

Le dessin représente, à titre d'exemple, une forme d'exécution de l'objet de l'invention et deux variantes.

La fig. 1 est une vue en plan d'une carte à puce.

La fig. 2 est une vue en perspective, à échelle agrandie, d'un détail de cette carte.

La fig. 3 est une coupe, à échelle encore agrandie, suivant la ligne III-III de la fig. 1, et

Les figs. 4 et 5 sont des vues en perspective, correspondant à celle de la fig. 2, de deux variantes.

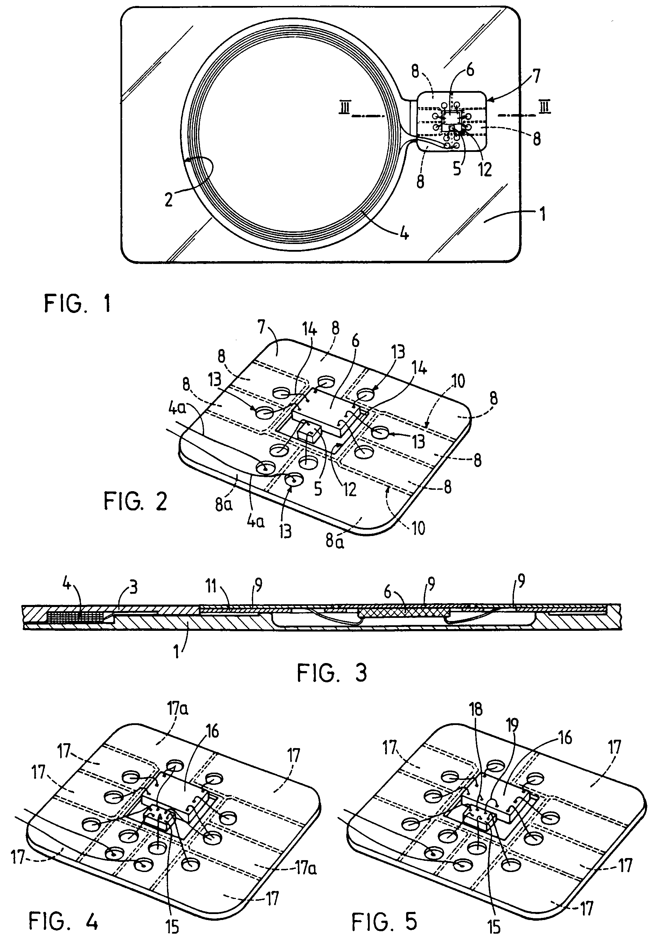

La carte informatique représentée aux figs. 1 à 3, en matière plastique, est désignée par 1. Elle présente une creusure circulaire 2, se fermant par un opercule 3, dans laquelle est logé un enroulement 4 constituant une antenne permettant la réception et l'émission, à distance, d'informations envoyées à un premier micro-circuit intégré 5 communément appelé "puce" (chip) contenant des mémoires d'informations à lecture seulement, c'est-à-dire dont les informations ne peuvent être ni modifiées ni remplacées par d'autres, car on ne peut, au moyen de l'antenne, transmettre à distance une énergie suffisante permettant l'introduction de données dans un micro-circuit intégré.

La présente carte informatique comprend un second micro-circuit intégré 6 (puce), à mémoires programmables,disposé à proximité immédiate du micro-circuit 5.

Les deux micro-circuits intégrés 5 et 6 sont disposés tous les deux sur un circuit imprimé 7 (print) présentant plusieurs plages conductrices 8. Ce circuit imprimé est formé d'éléments conducteurs minces 9 (fig. 3), en cuivre par exemple, séparés les uns des autres par des espaces 10, dont le nombre correspond au nombre des plages conductrices 8, et qui sont collées sur une feuille isolante 11. L'ensemble ainsi réalisé est logé dans une creusure de forme correspondante 12 ménagée dans la carte 1.

Cette feuille isolante 11 est percée d'un certain nombre d'ouvertures circulaires 13 situées chacune en regard d'une des plages conductrices 8. Ces ouvertures 13 permettent le passage de fils 14 (pattes) émanant des microcircuits intégrés 5 et 6 et le soudage de leurs extrémités sur les éléments conducteurs 9 du circuitimprimé 7. La feuille isolante 11 présente, en regard de deux des plages conductrices,désignées par 8a à la fig. 2, deux ouvertures supplémentaires 13 permettant le passage des deux extrémités, désignées par 4a, de l'enroulement 4 formant l'antenne et leur soudage sur ces deux plages conductrices.

La raison de ces deux ouvertures supplémentaires réside dans le fait que les fils 4a sont soudés aux éléments conducteurs 9 à l'étain alors que les fils 14 des microcircuits 5 et 6 sont soudés aux éléments 9 à l'or et qu'il n'est pas indiqué que ces deux matériaux soient en contact l'un avec l'autre.

Les éléments conducteurs 9 du circuit imprimé 7 étant accessibles de l'extérieur de la carte, cela permet, lorsque la carte est engagée dans un appareil de lecture-écriture, d'assurer la liaison électrique entre cet appareil et les plages conductrices 8, par contact physique, en vue de permettre la lecture d' informations contenues dans le micro-circuit intégré 6 et/ou l'envoi d'informations dans ce circuit modifiant ou remplaçant certaines des informations contenues dans ses mémoires.

Dans cette forme d'exécution, les deux microcircuits intégrés 5 et 6 ne sont pas reliés l'un à l'autre. Cependant, on pourra prévoir que telle ou telle information, en particulier une information d'identité et/ou d'habilité, indélébile, contenue dans la ou les mémoires du micro-circuit intégré d'antenne 5 soit répétée dans l'une ou l'autre des mémoires du micro-circuit intégré 6, ce qui permettrait de l'utiliser en combinaison avec des informations contenues dans ce circuit 6, pour certaines applications de la présente carte informatique, en particulier dans les cas de contrôle d'identité et/ou d'habilité.

Au contraire, dans les variantes des figs. 4 et 5, les deux micro-circuits intégrés, désignés par 15 et 16, ont certaines de leurs connexions qui aboutissent sur des mêmes plages conductrices 17a, lesquelles plages sont désignées d'une façon générale par 17 dans ces deux figures, de sorte que ces connexions sont ainsi reliées entre elles. De ce fait, il est également possible, dans ces deux variantes, d'introduire ou de modifier des données dans les mémoires du micro-circuit d'antenne 15. De plus, cette liaison entre les deux micro-circuits intégrés accroît les possibilités de modifier ou de compléter les informations qui peuvent être lues à distance par le moyen de l'antenne.

Dans la variante de la fig. 4, les liaisons entre les deux micro-circuits intégrés 15 et 16 sont assurées par l'intermédiaire des plages conductrices 17a, sans qu'il y ait de liaisons dans la carte elle-même. Dans le cas de la variante de la fig. 5, les deux micro-circuits intégrés 15 et 16 sont reliés directement l'un à l'autre par deux fils 18 et 19, le premier donnant un signal d'horloge au circuit 15 et le second assurant un transfert d'informations d'un circuit à l' autre.

Il en résulte que, dans le cas de la fig. 4, des informations venant de l'extérieur peuvent être introduites dans les mémoires des deux circuits intégrés simultanément et/ou dans l'un ou l'autre. De plus des informations peuvent être transférées d'un circuit intégré dans l'autre, mais obligatoirement par l'intermédiaire de l'appareil de lecture-écriture, de sorte qu'elles peuvent être connues et, le cas échéant, utilisées illicitement, puisque l'appareil "voit" passer les informations de transit.

Dans le cas de la fig. 5, au contraire, on ne donne des ordres qu'au circuit 16 et les informations qui transitent dans le circuit 15 n'apparaissent pas sur les plages conductrices du circuit imprimé avec lesquelles l'appareil de lecture-écriture est en contact, de sorte qu'elles sont indétectables par cet appareil.

Il est à remarquer que, dans le cas de la fig. 4, les circuits intégrés sont à mémoires avec accès série, alors que, dans le cas de la fig. 5, le circuit intégré 16 pourra contenir, outre des mémoires, un microprocesseur capable d'exécuter un programme de façon autonome.

Dans l'exemple et les variantes ci-dessus, les deux circuits intégrés constituent deux unités distinctes. On pourrait cependant concevoir le cas où ils formeraient ensemble un seul circuit intégré comprenant à la fois les éléments du circuit-antenne tel le circuit 5 de la forme d'exécution des figs. 1 à 3 et ceux du circuit-contact tel le circuit 6 de cette forme d'exécution.

## Revendications

1. Support portable d'informations numériques, caractérisé par le fait qu'il comprend au moins un micro-circuit intégré, du type dit "puce", relié à une antenne incorporée audit support, de manière à permettre une interrogation de ce circuit à distance et qui est relié à des moyens de contact matériel avec un dispositif de lecture-écriture, ce qui permet d'en lire les informations et d'y introduire des informations à l'aide dudit dispositif de lecture-écriture.

2. Support d'informations suivant la revendication 1, caractérisé par le fait que ledit micro-circuit intégré est constitué de deux unités distinctes, l'une reliée à l'antenne et l'autre destinée au dialogue par contact, ces deux unités étant toutes deux connectées à des plages de contact d'un circuit imprimé (print) porté par ledit support.

3. Support d'informations suivant la revendication 2, caractérisé par le fait qu'au moins une information contenue dans la première unité est identique à une des informations contenue dans la deuxième unité.

4. Support d'informations suivant la revendication 2, caractérisé par le fait que certaines des bornes des deux unités sont connectées à une même plage de contact du circuit imprimé.

5. Support d'informations suivant la revendication 2, caractérisé par le fait que certaines des bornes des deux unités sont reliées directement entre elles.
